# EUROPEAN PATENT APPLICATION

(11) **EP 2 672 586 A1**
(43) Date of publication of application: **11.12.2013**
(21) Application number: 12742218.6
(22) Date of filing: 30.01.2012
(51) Int. Cl.: H01T 4/10, H05K 1/02

(54) **COMPOSITION FOR FILLING DISCHARGING GAP AND ELECTROSTATIC DISCHARGE PROTECTOR**

(30) Priority: 02.02.2011 JP 2011020955
(71) Applicant: SHOWA DENKO K.K., Tokyo 105-8518 (JP)
(72) Inventor: ISHIHARA, Yoshimitsu, Tokyo 105-8518 (JP); ONISHI, Mina, Tokyo 105-8518 (JP); YOSHIDA, Shunsuke, Tokyo 105-8518 (JP)
(74) Representative: Strehl Schübel-Hopf & Partner
(86) International application number: PCT/JP2012/052029
(87) International publication number: WO 2012/105515

(57) **Abstract**

[Problem] To provide a discharge gap-filling composition having good coating properties (potting properties), and to provide an electrostatic discharge protector which can conveniently take ESD countermeasures in electronic circuit boards of various designs while having freedom of shape, has excellent operating properties during discharge and is capable of being downsized and reduced in cost, by the use of the composition.

[Solution] The discharge gap-filling composition of the present invention is characterized in that the composition comprises a metal powder (A), a binder component (B) and a diluent (C), the diluent (C) has two or more characteristic groups in a molecule, and the characteristic groups are not directly bonded to each other in a molecule but are bonded to each other through a hydrocarbon group or a silicon atom.

## Description

### TECHNICAL FIELD

The present invention relates to a discharge gap-filling composition having good coating properties (potting properties), and an electrostatic discharge protector which uses the discharge gap-filling composition, can conveniently take ESD countermeasures in electronic circuit boards of various designs while having freedom of shape, has excellent operating properties during discharge, is capable of being downsized and is capable of being reduced in cost by virtue of a rise of productivity in manufacturing.

### BACKGROUND ART

When a conductive object (e.g., human body) having been electrostatically charged comes. into contact with or comes sufficiently close to another conductive object (e.g., electronic equipment), vigorous discharge occurs. This phenomenon is called electrostatic discharge (also described as "ESD" hereinafter), and brings about problems such as malfunctions or damage of electronic equipments or sometimes becomes a cause of explosion in an explosive atmosphere.

ESD is one of destructive and inevitable phenomena to which electric systems and integrated circuits are exposed. Describing from the electrical viewpoint, ESD is a transient high current phenomenon in which a high current having a peak current of several amperes continues for 10 nsec to 300 nsec. Therefore, when ESD occurs, an integrated circuit suffers hardly restorable damage or suffers troubles or deterioration, unless a current of about several amperes is transmitted outside the integrated circuit within several tens nsec. As a result, an electronic part or electronic equipment containing the integrated circuit does not function normally.

In recent years, tendencies to weight lightening, thinning and downsizing of electronic parts and electronic equipments have been rapidly promoted. With such tendencies, the degree of integration of semiconductors or the packaging density of electronic parts on printed wiring boards have been markedly increased, so that electronic elements or signal lines having been too densely integrated or mounted are extremely close to each other. Moreover, the signal processing rate has been also raised. As a result, high-frequency radiation noises are liable to be induced. In such circumstances as above, development of electrostatic discharge protective elements to protect IC and the like in the circuit from ESD has been made.

As an electrostatic discharge protective element to protect IC and the like in the circuit from ESD, there was an element of a bulk structure composed of a sintered product of a metal oxide or the like in the past (see, for example, patent literature 1). This element is a laminate type chip varistor and has a laminate and a pair of external electrodes. Varistors have properties that when an applied voltage reaches a certain value or more, a current that has not flow till then abruptly flows, and they exhibit excellent inhibitory power against the electrostatic discharge. However, the laminate type chip varistor that is a sintered product cannot avoid a complicated production process comprising sheet forming, internal electrode printing, sheet laminating, etc., and besides, there is a problem that troubles such as delamination are liable to occur in the mounting step.

As another electrostatic discharge protective element to protect IC and the like in the circuit from ESD, there is a discharge type element. The discharge type element has advantages that the leakage current is small, the structure is theoretically simple, and troubles rarely occur. Further, the discharge voltage can be adjusted by the width of the discharge gap. Furthermore, when the element has a sealed structure, the width of the discharge gap can be determined according to the pressure of a gas and the type of a gas. As the discharge type element that is actually on the market, there is an element obtained by forming a columnar conductive film with a ceramic surface, providing a discharge gap in the film by means of laser or the like and subjecting it to glass tube sealing. Although this commercially available discharge type element of glass sealed tube is excellent in electrostatic discharge protection properties, it has a limit of size as a small-sized element for surface mounting because its structure is complicated. In addition, there is a problem that the cost reduction is difficult.

Further, there has been disclosed a method in which a discharge gap is directly formed on a wiring, and by the width of the discharge gap, a discharge voltage is adjusted (see, for example, patent literatures 2 to 4). In the patent literature 2, a discharge gap width of 4 mm is exemplified, and in the patent literature 3, a discharge gap width of 0.15 mm is exemplified. In the patent literature 4, it has been disclosed that, for the protection of an ordinary electronic element, the discharge gap is preferably 5 to 60 µm, and for the protection of IC or LSI that is more sensitive to the electrostatic discharge, the discharge gap is preferably 1 to 30 µm, and in the use where it is enough just to remove only a portion of particularly large pulse voltage, the discharge gap can be increased up to about 150 µm.

However, if the discharge gap part is not protected, gaseous discharge is brought about by application of a high voltage, or the surface of the conductor is contaminated because of humidity or gas in the environment to thereby change a discharge voltage, or there is a possibility of short circuit of an electrode because of carbonization of a substrate on which the electrode has been provided.

For the electrostatic discharge protector having a discharge gap, high insulation resistance is required at a normal operating voltage, for example, generally at less than DC10V, and therefore, it becomes effective to provide an insulating member of voltage resistance in the discharge gap between a pair of electrodes. If the discharge gap is directly filled with an ordinary resist as the insulating member in order to protect the discharge gap, a marked rise of a discharge voltage takes place, and this is not practical. When an extremely narrow discharge gap of about 1 to 2 µm or less than it is filled with an ordinary resist, the discharge voltage can be lowered. However, the resist used for filling suffers slight deterioration, or the insulation resistance is lowered, or electrical conduction takes place in some cases.

In a patent literature 5, a protective element obtained by providing a discharge gap of 10 to 50 µm on an insulating substrate and providing a functional film containing silicon carbide having ZnO as a main component between a pair of electrode patterns whose ends face each other has been disclosed. This protective element has an advantage that it has simple constitution as compared with the laminate type chip varistor and can be produced as a thick film element on a substrate.

As for these ESD countermeasure elements, reduction of mounting area has been achieved with development of electronic equipments. However, their shapes are absolutely those of elements, so that it is necessary to mount them on wiring boards by a solder or the like. On this account, the degree of freedom of design is low, and there is limitation on the reduction of size including height.

Accordingly, it has been desired that ESD countermeasures can be taken with freedom of shape including downsizing at necessary positions with necessary area, without fixing an element.

On the other hand, in a patent literature 6, it has been disclosed to use a resin composition as an ESD protective material. The resin composition referred to herein is characterized by containing a base material made of a mixture of insulating binders, conductive particles having a mean particle diameter of less than 10 µm and semiconductor particles having a mean particle diameter of less than 10 µm.

In a patent literature 7, a composition material in which a mixture of conductive particles and semiconductor particles, whose surfaces have been each coated with an insulating oxide film, is bound by an insulating binder, a composition material in which a range of particle diameters is defined, a composition material in which spacing between conductive particles is defined, etc. have been disclosed as the ESD protective materials.

### CITATION LIST

### PATENT LITERATURE

Patent literature 1: JP 2005-353845 A
Patent literature 2: JP 1991(H03)-89588 A
Patent literature 3: JP 1993(H05)-67851 A
Patent literature 4: JP 1998(H10)-27668 A
Patent literature 5: JP 2007-266479 A
Patent literature 6: JP 2001-523040 A
Patent literature 7: U.S. Patent No. 4,726,991

### SUMMARY Of INVENTION

### TECHNICAL PROBLEM

However, in the case where a thin film is formed by applying the composition disclosed in any of the patent literatures 6 to 7 to the desired portion, it is difficult to apply the composition with good productivity, and there is room for improvement in productivity of electrostatic discharge protectors. In the case where a thin film is formed by decreasing the viscosity of the composition and applying the composition to the desired portion, particle components in the composition, such as a metal powder, are liable to be precipitated, and discharge of the composition during the application sometimes becomes unstable.

The present invention is intended to solve such problems as above, and it is an obj ect of the present invention to provide a discharge gap-filling composition having good coating properties (potting properties), and an electrostatic discharge protector which uses the discharge gap-filling composition, can conveniently take ESD countermeasures in electronic circuit boards of various designs while having freedom of shape, has excellent operating properties during discharge, is capable of being downsized and is capable of being reduced in cost by virtue of a rise of productivity in manufacturing.

### SOLUTION TO PROBLEM

The present inventors have earnestly studied in order to solve the above problems associated with the prior art, and as a result, they have found that coating properties (potting properties) of a discharge gap-filling composition comprising a metal powder, a binder component and a diluent become good by using, as the diluent, a diluent having two or more characteristic groups in a molecule, said characteristic groups being not directly bonded to each other in a molecule but being bonded to each other through a hydrocarbon group or a silicon atom.

Further, the present inventors have also found that an electrostatic discharge protector using such a discharge gap-filling composition can conveniently take ESD countermeasures in electronic circuit boards of various designs while having freedom of shape, has excellent operating properties during discharge, is capable of being downsized, and is capable of being reduced in cost by virtue of a rise of productivity in manufacturing.

That is to say, the present invention has been accomplished based on such findings as above, and is specifically as follows.
[1] A discharge gap-filling composition comprising a metal powder (A), a binder component (B) and a diluent (C), wherein the diluent (C) has two or more characteristic groups in a molecule, and the characteristic groups are not directly bonded to each other in a molecule but are bonded to each other through a hydrocarbon group or a silicon atom.
[2] The discharge gap-filling composition as stated in claim 1, wherein the content of the binder component (B) is 10 to 90 parts by mass and the content of the diluent (C) is 50 to 10000 parts by mass, based on 100 parts by mass of the content of the metal powder (A).
[3] The discharge gap-filling composition of [1] or [2], wherein the characteristic groups of the diluent (C) are hydrophilic characteristic groups.
[4] The discharge gap-filling composition of any one of [1] to [3], wherein the characteristic groups of the diluent (C) are hydrophilic characteristic groups each containing at least one atom selected from the group consisting of a nitrogen atom, an oxygen atom, a phosphorus atom, a sulfur atom and a halogen atom.
[5] The discharge gap-filling composition of any one of [1] to [4], wherein the characteristic groups of the diluent (C) are each selected from the group consisting of a hydroxyl group, an oxy group at least one of two bonding hands of which is not bonded to a hydrocarbon group, an oxo group, a carbonyl group, an amino group, an imino group, a halogen group, an N-oxide group, an N-hydroxyl group, a hydrazine group, a nitro group, a nitroso group, an azo group, a diazo group, an azide group, a phosphino group, a thiosulfide group at least one of two bonding hands of which is not bonded to a hydrocarbon group, an S-oxide group, a thioxy group and groups in which these are directly bonded to each other.
[6] The discharge gap-filling composition of any one of [1] to [5], wherein the characteristic groups of the diluent (C) are each selected from the group consisting of a hydroxyl group, an oxy group at least one of two bonding hands of which is not bonded to a hydrocarbon group, an oxo group, a carbonyl group, and groups in which these are directly bonded to each other.
[7] The discharge gap-filling composition of any one of [1] to [6], wherein the diluent (C) is at least one substance selected from the group consisting of dipropylene glycol, triacetin, glycerol, 1,1,3,3-tetramethoxypropane and 1,1,3,3-tetraethoxypropane.
[8] The discharge gap-filling composition of any one of [1] to [7], wherein the surfaces of primary particles of the metal powder (A) are coated with a film made of a metal oxide.
[9] The discharge gap-filling composition of [8], wherein the film made of a metal oxide is a film made of a hydrolysis product of a metal alkoxide represented by the following formula (1): 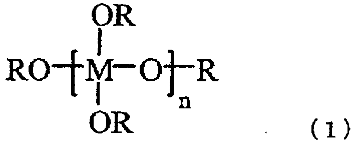 wherein M is a metal atom, O is an oxygen atom, each R is independently an alkyl group of 1 to 20 carbon atoms, and n is an integer of 1 to 40.
[10] The discharge gap-filling composition of [9], wherein M in the formula (1) is silicon, titanium, zirconium, tantalum or hafnium.
[11] The discharge gap-filling composition of any one of [1] to [10], which further comprises a layered substance (D).
[12] The discharge gap-filling composition of [8], wherein the film made of a metal oxide is a self-oxidation film formed from the primary particle itself of the metal powder (A).
[13] The discharge gap-filling composition of any one of [1] to [12], wherein the metal powder (A) is at least one metal powder selected from the group consisting of copper, silver, gold, zinc, iron, tungsten, manganese, niobium, zirconium, hafnium, tantalum, molybdenum, vanadium, nickel, cobalt, chromium, magnesium, titanium, aluminum and alloys of these metals.
[14] The discharge gap-filling composition of any one of [1] to [13], wherein the binder component (B) contains a thermosetting compound or an active energy ray-curable compound.
[15] An electrostatic discharge protector having at least two electrodes and a discharge gap between the two electrodes, and having a discharge gap filler member formed by filling the discharge gap with the discharge gap-filling composition of any one of [1] to [14].
[16] An electronic circuit board having the electrostatic discharge protector of [15].
[17] A flexible electronic circuit board having the electrostatic discharge protector of [15].

### EFFECT OF THE INVENTION

In the discharge gap-filling composition of the present invention, aggregation of particle components such as a metal powder in the composition is reduced, and precipitation of the particle components with time rarely occurs. Therefore, the composition can exhibit good coating properties (potting properties), and owing to this, a small-sized electrostatic discharge protector having excellent operating properties during discharge can be produced at a low cost, and electrostatic protection can be simply realized. If the discharge gap-filling composition of the present invention is used, adjustment of the operating voltage becomes possible by setting the width of the discharge gap to a specific distance, and therefore, an electrostatic discharge protector having excellent precision in adjustment of the operating voltage can be obtained.

The electrostatic discharge protector of the present invention is produced by forming a discharge gap corresponding to a necessary operating voltage in a necessary space between electrodes, then filling the discharge gap with the discharge gap-filling composition and solidifying or curing the composition. Therefore, this electrostatic discharge protector can conveniently take ESD countermeasures in electronic circuit boards of various designs while having freedom of shape, has excellent operating properties during discharge, is capable of being downsized and is capable of being reduced in cost by virtue of a rise of productivity in manufacturing. On this account, the electrostatic discharge protector of the present invention can be preferably utilized for digital equipments, such as cellular phones, and mobile equipments which are liable to be statically electrified because they are frequently touched by human hands.

### BRIEF DESCRIPTION OF DRAWINGS

[Fig. 1] Fig. 1 is a vertical sectional view of an electrostatic discharge protector 11 which is a specific example of the electrostatic discharge protector of the present invention.
[Fig. 2] Fig. 2 is a vertical sectional view of an electrostatic discharge protector 21 which is a specific example of the electrostatic discharge protector of the present invention.
[Fig. 3] Fig. 3 is a vertical sectional view of an electrostatic discharge protector 31 which is a specific example of the electrostatic discharge protector of the present invention.
[Fig. 4] Fig. 4 is a scanning electron microscope (SEM) image of a surface-coated aluminum particle prepared in Preparation Example 1.
[Fig. 5] Fig. 5 is a scanning electron microscope (SEM) image of a surface-coated aluminum particle prepared in Preparation Example 2.

### EMBODIMENT FOR CARRYING OUT THE INVENTION

The present invention is described in detail hereinafter.

### <Discharge gap-filling composition>

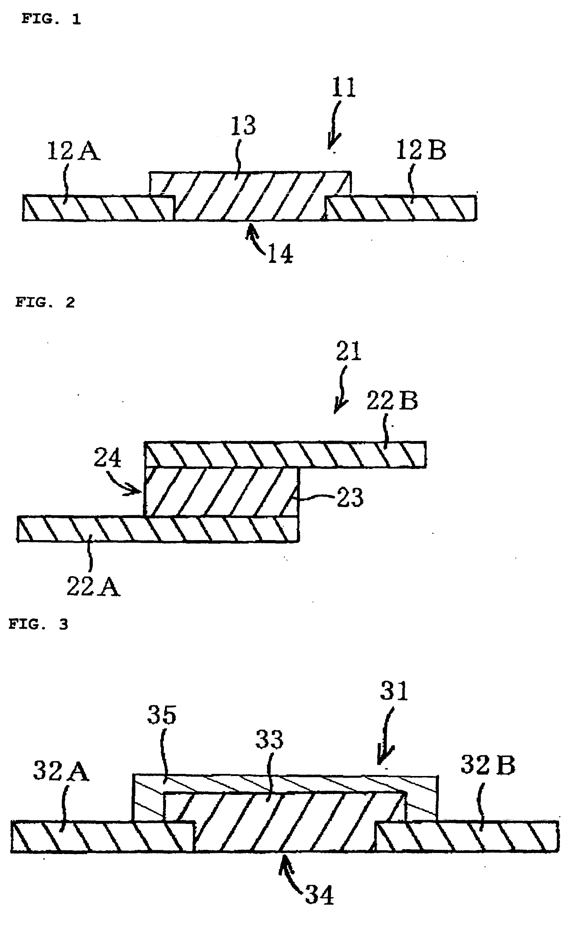

The discharge-gap filling composition of the present invention is a composition which contains a metal powder (A), a binder component (B) and a diluent (C) as essential components and may contain a layered substance (D) and other components, if necessary, and is characterized in that the diluent (C) has two or more characteristic groups in a molecule and the characteristic groups are not directly bonded to each other in a molecule but are bonded to each other through a hydrocarbon group or a silicon atom, as described later. In the present specification, the discharge gap-filling composition is referred to such a composition used in order to fill a space ("discharge gap") present between a pair of electrodes as denoted by reference numerals 14, 24 and 34 in Figs. 1 to 3.

### [Metal powder (A)]

The metal powder (A) for use in the present invention is not specifically restricted as far as it is a powder made of a publicly known metal. However, the metal powder is preferably at least one powder selected from the group consisting of copper, silver, gold, zinc, iron, tungsten, manganese, niobium, zirconium, hafnium, tantalum, molybdenum, vanadium, nickel, cobalt, chromium, magnesium, titanium, aluminum and alloys of these metals.

The surfaces of primary particles of the metal powder (A) are preferably coated with a film made of a metal oxide. If the surfaces of primary particles of the metal powder (A) are coated with a film made of a metal oxide, the surface of the metal powder (A) can partially exhibit moderate insulation properties and high resistance to voltage. The discharge gap-filling composition containing such a metal powder (A) exhibits insulation properties at a voltage of normal operation but becomes conductive when loaded with a high voltage during electrostatic discharge. It is thought that as a result of this, an electrostatic discharge protector using the discharge gap-filling composition exhibits effective electrostatic discharge protection properties, and an electronic circuit board or a flexible electronic circuit board having this electrostatic discharge protector is rarely destroyed at a high voltage.

The film made of the metal oxide is not specifically restricted provided that the film exhibits the above properties, and for example, a film made of a hydrolysis product of a metal alkoxide, an oxide film formed from a primary particle itself of the metal powder (A) (also described as a "self-oxidation film"), etc. can be mentioned.

The metal atom to constitute the metal alkoxide is not specifically restricted provided that the metal atom can form a hydrolysis product by the reaction with water alone or water and a hydrolysis catalyst. In the present invention, semi-metals, such as silicon, germanium and tin, are also included in the metal atoms. As the metal atoms, magnesium, aluminum, gallium, indium, thallium, silicon, germanium, tin, titanium, zirconium, hafnium, tantalum and niobium are preferable. Of these, silicon, titanium, zirconium, tantalum or hafnium is more preferable, and silicon is still more preferable.

The alkoxide of silicon is rarely hydrolyzed by moisture or the like in air, and the hydrolysis rate is easily controlled, so that when the surfaces of the primary particles of the metal powder (A) are coated with a film made of a hydrolysis product of the alkoxide of silicon, production stability is further enhanced.

The metal alkoxide is preferably represented by the following formula (1). If the metal alkoxide is such a metal alkoxide, formation of a film of a metal oxide tends to become easy when the metal alkoxide is hydrolyzed.

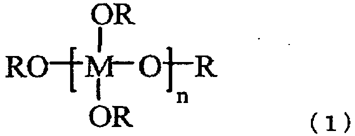

In the general formula (1), M is a metal atom, O is an oxygen atom, each R is independently an alkyl group of 1 to 20 carbon atoms, and n is an integer of 1 to 40.

M in the general formula (1) is preferably silicon, titanium, zirconium, tantalum or hafnium. When M is such a metal atom, voltage resistance of the finally obtained electrostatic discharge protector tends to become good.

In the general formula (1), R is an alkyl group of 1 to 20 carbon atoms and is preferably an alkyl group of 1 to 12 carbon atoms. Examples of such alkyl groups include methyl, ethyl, n-propyl, isopropyl, n-butyl, sec-butyl, tert-butyl, n-pentyl, 1-methylbutyl, 2-methylbutyl, 3-methylbutyl, neopentyl, 1-ethylpropyl, n-hexyl, 1,1-dimethylpropyl, 1,2-dimethylpropyl, 1,2-dimethylpropyl, 1-methylpentyl, 2-methylpentyl, 3-methylpentyl, 4-methylpentyl, 1,1-dimethylbutyl, 1,2-dimethylbutyl, 1,3-dimethylbutyl, 2,2-dimethylbutyl, 2,3-dimethylbutyl, 3,3-dimethylbutyl, 1-ethylbutyl, 2-ethylbutyl, 1,1,2-trimethylpropyl, 1,2,2-trimethylpropyl, 1-ethyl-1-methylpropyl, 1-ethyl-2-methylpropyl, n-heptyl, n-octyl, n-nonyl, n-decyl and n-dodecyl. Of these, methyl, ethyl, n-propyl, isopropyl, n-butyl, sec-butyl, isobutyl and n-pentyl are preferable, and ethyl, n-propyl and n-butyl are more preferable.

When the molecular weight of the alkyl group is high, hydrolysis of the metal oxide represented by the general formula (1) gently proceeds. However, if the molecular weight of the alkyl group is too high, the metal alkoxide represented by the general formula (1) becomes wax-like, and uniform dispersing tends to become difficult.

If the number of n is too large in the metal alkoxide represented by the formula (1), viscosity of the metal alkoxide itself increases, and it becomes difficult to disperse it, so that n is desirably an integer of 1 to 4. Especially in the case of a monomer (n in the formula (1) = 1), the reaction abruptly occurs, and many suspended particles are sometimes formed, so that it is desirable to use a condensate, such as a dimer (n in the formula (1) = 2), a trimer (n in the formula (1) = 3) or a tetramer (n in the formula (1) = 4).

Examples of the metal alkoxides for use in the present invention include tetramethoxysilane, tetraethoxysilane, tetraethyl titanate, tetraisopropyl titanate, tetra-n-butyl titanate, tetra-sec-butyl titanate, tetra-tert-butyl titanate, tetra-2-ethylhexyl titanate, tetraethyl zirconate, tetraisopropyl zirconate, tetra-n-butyl zirconate, tetra-sec-butyl zirconate, tetra-tert-butyl zirconate, tetra-2-ethylhexyl zirconate, and condensates thereof. From the viewpoints of hydrolysis properties and dispersibility, tetraethoxysilane is particularly preferable. These metal alkoxides may be used singly, or may be used by mixing two or more kinds.

The method to coat the surface of the primary particle of the metal powder (A) with a film made of a hydrolysis product of the metal alkoxide is, for example, a method wherein to a solvent suspension of the metal powder (A), a metal alkoxide and water in an amount capable of hydrolyzing the metal alkoxide are slowly added to perform coating. Through this method, a hydrolyzate containing a metal oxide or the like is formed from the metal alkoxide, and the surface of the primary particle of the metal powder (A) can be coated with the hydrolysis product.

It is thought that when M is, for example, silicon in the metal alkoxide represented by the general formula (1), silicon dioxide, or an oligomer or a polymer that is a dehydrocondensation product of silanol, or a mixture thereof is formed through the hydrolysis, and the surface of the primary particle of the metal powder (A) is coated with a film made of a metal oxide such as silicon dioxide.

As the method of adding the metal alkoxide and water, a method of adding them at a time may be adopted, or a method of adding them by portions in plural stages may be adopted. With regard to the order of addition of them, water may be added after the metal alkoxide is dissolved or suspended in a solvent, or the metal alkoxide may be added after water is dissolved or suspended in a solvent, or they may be alternately added by portions. In general, however, as the reaction is carried out more gently, suspended particles tend to be less formed, and therefore, a method of adding them by portions in plural stages is preferable, and a method of adding them while lowering the concentration by the use of a solvent if necessary is more preferable.

The solvents are desirably solvents capable of dissolving the metal alkoxide, such as alcohols, mineral spirits, solvent naphtha, benzene, toluene, xylene and petroleumbenzene. However, the solvents are not specifically restricted because the metal alkoxide undergoes reaction in a suspended state. These solvents may be used singly or by mixing two or more kinds. In the hydrolysis reaction of the metal oxide, an alcohol is formed as a side product by the addition of water, so that it is possible to use the alcohol as a regulator of the polymerization rate.

As previously described, the film made of the metal oxide may be a self-oxidation film formed from the primary particle itself of the metal powder (A). In the present invention, the self-oxidation film is referred to an oxide film obtained by oxidation of the metal atom on the surface of the primary particle of the metal powder (A).

It is thought that the metal powder (A) whose primary particles have been each coated with a self-oxidation film has insulation properties at a voltage of normal operation because the oxide film has insulation properties, but it becomes conductive when loaded with a high voltage during electrostatic discharge, and by removing a high voltage, the insulation properties are restored. Accordingly, it is thought that an electrostatic discharge protector using the discharge gap-filling composition containing the metal powder (A) whose primary particles have been each coated with a self-oxidation film exhibits effective electrostatic discharge protection properties, and an electronic circuit board or a flexible electronic circuit board having this electrostatic discharge protector is rarely destroyed at a high voltage.

As the metal powder (A) coated with a self-oxidation film, a powder of a general metal publicly known can be used. However, preferable as the metal powder (A) is a metal powder wherein in spite of a marked ionization tendency, a metal atom on the primary particle surface is oxidized to form a dense self-oxidation film, whereby the inside can be protected, that is, a metal powder which can be in a passive state. Examples of such metal powders include powders of copper, zinc, iron, tungsten, manganese, niobium, zirconium, hafnium, tantalum, molybdenum, vanadium, nickel, cobalt, chromium, magnesium, titanium, aluminum and alloys of these metals. Of these, a powder of aluminum, nickel, tantalum, titanium or an alloy thereof is most preferable from the viewpoints of inexpensiveness and ease of obtaining.

As the metal powder, further, a powder of vanadium oxide that is used in a thermistor whose resistance value abruptly changes at a specific temperature can be effectively used.

The above metal powders (A) can be used singly or by mixing two or more kinds.

As the method to form the self-oxidation film on the surface of the primary particle of the metal powder (A), there can be mentioned, for example, a method of heating the metal powder in the presence of oxygen to form a self-oxidation film. However, a self-oxidation film having a more stable structure can be formed by the following method. That is to say, the surface of the primary particle of the metal powder is purified by an organic solvent such as acetone, then the surface of the primary particle of the metal powder is slightly etched with dilute hydrochloric acid, and the metal powder is heated for about one hour at a temperature lower than the melting point of the metal powder itself (in the case of a metal other than aluminum: e.g., 750°C, in the case of aluminum: e.g., 600°C) in an atmosphere of a mixed gas consisting of 20% by volume of hydrogen gas and 80% by volume of argon gas (mixed gas = 100% by volume) and further heated for 30 minutes in a high-purity oxygen atmosphere, whereby a uniform self-oxidation film can be formed on the surface of the primary particle of the metal powder with high controllability and good reproducibility. According to this method, dielectric breakdown voltage of the self-oxidation film formed on the surface of the primary particle of the metal powder tends to rarely become non-uniform in one product or among products.

In such a method for coating the surface of the primary particle of the metal powder (A) with the film made of a metal oxide as above, the film thickness of the coating film can be adjusted to about 10 nm to 2 µm. The film thickness of the coating film can be determined by the use of, for example, a transmission electron microscope. The occupied area of the coating region on the surface of the primary particle may be such a degree that a part of the surface of the primary particle of the metal powder (A) is coated with the film made of the metal oxide, but it is preferable that the whole surface of the primary particle is coated with the film made of the metal oxide.

Even if the primary particles of the metal powder (A) are not independently coated with the film made of the metal oxide, it is enough that all the spaces among the particles are filled with the film made of the metal oxide.

Especially in the case where the surfaces of the primary particles of the metal powder (A) are each coated with the film made of the metal oxide, the particle surfaces show moderate insulation properties, and therefore, the particles maybe present so as to overlap one another. However, if the ratio of the binder component (B) is low, problems such as powder fall sometimes take place. On that account, when utility, rather than operating properties, is taken into account, the occupancy ratio by mass of the metal powder (A) is preferably not more than 95% by mass in the solids content (100% by mass) of the discharge gap-filling composition.

When ESD occurs, the electrostatic discharge protector is required to exhibit electrical conductivity as a whole, and therefore, there is a preferred lower limit of the occupancy ratio by mass. That is to say, the occupancy ratio by mass of the metal powder (A) is preferably not less than 30% by mass in the solids content (100% by mass) of the discharge gap-filling composition.

Accordingly, when the discharge gap-filling composition of the present invention is used for the electrostatic discharge protector, the occupancy ratio by mass of the metal powder (A) is preferably not less than 30% by mass but not more than 95% by mass in the solids content (100% by mass) of the discharge gap-filling composition.

The shape of the primary particle of the metal powder (A) for use in the present invention is preferably a thin-leaf shape.

Here, the thin-leaf shape is referred to a shape having a small thickness and an extended plane, and examples thereof include shapes of a flake, a disk, a strip and a layer. However, a shape of a sphere or the like is not included. As for the thickness and the plane of the primary particle of the metal powder (A), the thin-leaf shape is specifically a shape in which the maximum length of the plane in the lengthwise direction is not less than twice the mean thickness, and the maximum length of the plane in the crosswise direction is not less than twice the mean thickness. Although the upper limit of the maximum length of the plane in the lengthwise direction is not specifically restricted, it is not more than 1000 times the mean thickness. Although the upper limit of the maximum length of the plane in the crosswise direction is not specifically restricted, it is not more than 1000 times the mean thickness.

When the shape of the primary particle of the metal powder (A) in the discharge gap-filling composition of the present invention is a thin-leaf shape, an electrostatic discharge protector using the discharge gap-filling composition tends to have good operating properties during discharge.

As the primary particle of the metal powder (A), a primary particle having a mean thickness (d) of not more than 1 µm can be used, and the mean thickness is preferably not more than 0. 5 µm, most preferably not more than 0.3 µm.

In the primary particle of the metal powder (A), the mean aspect ratio (L/d) is preferably not less than 3 but not more than 1000, more preferably not less than 5 but not more than 500, still more preferably not less than 10 but not more than 100.

When the primary particle of the metal powder (A) in the discharge gap-filling composition of the present invention has a mean aspect ratio (L/d) of the above range, discharge is apt to be carried out more smoothly in the discharge direction. As a result, the electrostatic discharge protector using the discharge gap-filling composition has good operating voltage and good resistance to high voltage. That is to say, it is thought that the operating properties of the protector become good, and besides, properties of a protector capable of coping with even discharge at a lower voltage are exhibited.

Here, the "aspect ratio (L/d)" is referred to a ratio ("L/d") of a length ("L") of the longest axis (longer side) to a length ("d") of the shortest axis corresponding thereto in the primary particle of the metal powder (A).

The aspect ratio (L/d) of the primary particle of the metal powder (A) is measured in the following manner. The metal powder (A) having been subjected to formation of section is observed under a scanning electron microscope at 5000 to 30000 magnifications. From the primary particles of the metal powder (A) observed, 10 primary particles are arbitrarily selected, and a length "L" of the longest axis (longer side) and a length "d" of the shortest axis corresponding thereto in each of the selected primary particles are measured. Then, from the measured L values and d values of the 10 primary particles, a mean value of L and a mean value of d are calculated, and from the mean value of L and the mean value of d, a mean aspect ratio (L/d) can be determined.

### [Binder component (B)]

In the present invention, the binder component (B) is referred to an insulator substance for dispersing particle components, such as the above-mentionedmetal powder (A) and the later-described layered substance (D).

The binder component (B) is, for example, a polymer (organic polymer, inorganic polymer, or composite polymer thereof) having a volume resistivity (in accordance with JIS 6911) of not less than 1×10¹⁰ Ω·cm, preferably 1×10¹⁰ to 10×10¹⁶ Ω·cm.

Examples of such binder components (B) include polysiloxane compound, urethane resin, polyimide, polyolefin, polybutadiene, epoxy resin, phenol resin, acrylic resin, hydrogenated polybutadiene, polyester, polycarbonate, polyether, polysulfone, polytetrafluoro resin, melamine resin, polyamide, polyamidoimide, phenol resin, unsaturated polyester resin, vinyl ester resin, alkyd resin, vinyl ester resin, alkyd resin, diallyl phthalate resin, allyl ester resin and furan resin.

From the viewpoints of mechanical stability, thermal stability, chemical stability and stability with time, the binder component (B) preferably contains a thermosetting compound or an active energy ray curing compound. Of such thermosetting compounds, a thermosetting urethane resin is particularly preferable because it has a high insulation resistance value and good adhesion to a base and the dispersibility of the metal powder (A) in it is good.

The compounds contained in the binder component (B) may be used singly or in combination of two or more kinds.

The thermosetting urethane resin is, for example, a polymer having a urethane bond, which is formed by allowing a polyol compound including a carbonate diol compound to react with an isocyanate compound. A carboxyl group-containing thermosetting urethane resin further having a carboxyl group in a molecule or an acid anhydride group-containing thermosetting urethane resin further having an acid anhydride group at a molecular end is preferable because a function of curing reaction with other curing components is imparted. As examples of the other curing components, epoxy resin curing agents, etc. can be given, and such a curing component can be used as one of the binder components (B).

Examples of the carbonate diol compounds include a carbonate diol compound containing, as constituent units, repeating units derived from one or more linear aliphatic diols, a carbonate diol compound containing, as constituent units, repeating units derived from one or more alicyclic diols, and a carbonate diol compound containing, as constituent units, repeating units derived from both of these diols.

Examples of the carbonate diol compounds containing, as constituent units, repeating units derived from linear aliphatic diol include polycarbonate diols having a structure in which diol components, such as 1,3-propanediol, 1,4-butanediol, 1,5-pentanediol, 1,6-hexanediol, 3-methyl-1,5-pentanediol, 2-methyl-1,8-octanediol and 1,9-nonanediol, are linked by a carbonate bond.

Examples of the carbonate diol compounds containing, as constituent units, repeating units derived from alicyclic diol include polycarbonate diols having a structure in which diol components, such as 1,4-cyclohexanedimethanol, 1,3-cyclohexanedimethanol, 1,4-cyclohexanediol, 1,3-cyclohexanediol, tricyclohexanedimethanol and pentacyclopentadecanedimethanol, are linked by a carbonate bond. Two or more kinds of these diol components may be combined.

Examples of the carbonate diol compounds that are on the market include PLACCEL, CD-205, 205PL, 205HL, 210, 210PL, 210HL, 220, 220PL and 220HL (trade names, manufactured by Daicel Chemical Industries, Ltd.), UC-CARB100, UM-CARB90 and UH-CARB100 (trade names, manufactured by Ube Industries, Ltd.), and C-1065N, C-2015N, C-1015N and C-2065N (trade names, manufactured by Kuraray Co., Ltd.).

These carbonate diol compounds can be used singly or in combination of two or more kinds. Of these, polycarbonate diol containing, as constituent units, repeating units derived from linear aliphatic diol tends to be excellent in low warpage properties and flexibility. Therefore, in the case where the binder component (B) containing the polycarbonate diol is used, it becomes easy to provide the later-described electrostatic discharge protector on a flexible wiring board.

The polycarbonate diol containing, as constituent units, repeating units derived from alicyclic diol tends to have high crystallizability and have excellent heat resistance. From the above viewpoints, it is preferable to use these polycarbonate diols in combination of two or more kinds or to use polycarbonate diol containing, as constituent units, repeating units derived from both of linear aliphatic diol and alicyclic diol. In order that flexibility and heat resistance may be exhibited with a good balance, it is preferable to use polycarbonate diol having a copolymerization ratio between the linear aliphatic diol and the alicyclic diol of 3:7 to 7:3 by mass.

The number-average molecular weight of the polycarbonate diol compound is preferably not more than 5000. If the number-average molecular weight exceeds 5000, the relative quantity of urethane bonds is decreased, and therefore, operating voltage of the electrostatic discharge protector sometimes rises, or the resistance to high voltage is sometimes lowered.

Examples of the isocyanate compounds include diisocyanates, such as 2,4-toluene diisocyanate, 2,6-toluene diisocyanate, iosphorone diisocyanate, hexamethylene diisocyanate, diphenylmethylene diisocyanate, (o, m or p)-xylene diisocyanate, (o, m or p)-hydrogenated xylene diisocyanate, methylenebis(cyclohexyl isocyanate), trimethylhexamethylene diisocyanate, cyclohexane-1,3-dimethylene diisocyanate, cyclohexane-1,4-dimethylene diisocyanate, 1,3-trimethylene diisocyanate, 1,4-tetramethylene diisocyanate, 2,2,4-trimethylhexamethylene diisocyanate, 2,4,4-trimethylhexamethylene diisocyanate, 1,9-nonamethylene diisocyanate, 1,10-decamethylene diisocyanate, 1,4-cyclohexane diisocyanate, 2,2'-diethyl ether diisocyanate, cyclohexane-1,4-dimethylene diisocyanate, 1,5-nahthalene diisocyanate, p-phenylene diisocyanate, 3,3'-methyleneditolylene-4,4'-diisocyanate, 4,4'-diphenyl ether diisocyanate, tetrachlorophenylene diisocyanate, norbornane diisocyanate and 1,5-naphthalene diisocyanate. These isocyanate compounds can be used singly or in combination of two or more kinds.

Of these, alicyclic diisocyanate derived from alicyclic diamine, specifically, isophorone diisocyanate or (o, m or p)-hydrogenated xylenediisocyanate, ispreferable. When these diisocynates are used, cured products having excellent resistance to high voltage can be obtained.

In order to particularly obtain the carboxyl group-containing thermosetting urethane resin as the thermosetting urethane resin for use in the present invention, it is enough just to subject a polyol having a carboxyl group to the reaction together with the carbonate diol compound and the isocyanate compound.

As the polyol having a carboxyl group, a dihydroxyl aliphatic carboxylic acid having a carboxyl group is particularly preferably used. Examples of such dihydroxyl compounds include dimethylolpropionic acid and dimethylolbutanoic acid. By the use of the dihydroxy aliphatic carboxylic acid having a carboxyl group, a carboxyl group can be easily allowed to be present in the urethane resin.

In order to particularly obtain the acid anhydride group-containing thermosetting urethane resin as the thermosetting urethane resin for use in the present invention, for example, a second diisocyanate compound, which is obtained by allowing the above carbonate diol compound and the above isocyanate compound to react with each other so that the ratio of the number of hydroxyl groups to the number of isocyanate groups may become 1.01 or more (isocyanate groups/hydroxyl groups), is allowed to react with a polycarboxylic acid having an acid anhydride group or a derivative thereof.

Examples of the polycarboxylic acids having an acid anhydride group and the derivatives thereof include trivalent polycarboxylic acids having an acid anhydride group and derivatives thereof, and tetravalent polycarboxylic acids having an acid anhydride group and derivatives thereof.

The trivalent polycarboxylic acids having an acid anhydride group and the derivatives thereof are not specifically restricted, but there can be mentioned, for example, compounds represented by the following formula (2) and the following formula (3):

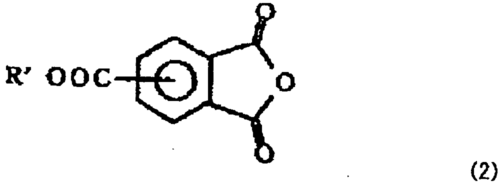

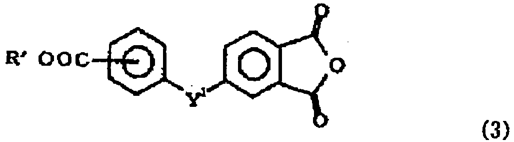

wherein R' is hydrogen, an alkyl group of 1 to 10 carbon atoms or a phenyl group, and Y¹ is -CH₂-, -CO-, -SO₂- or -O-.
Of the trivalent polycarboxylicacids having an acid anhydride group and the derivatives thereof, trimellitic anhydride is particularly preferable from the viewpoints of heat resistance, cost, etc.

In addition to the polycarboxylic acid or its derivative, tetracarboxylic dianhydride, an aliphatic dicarboxylic acid or an aromatic dicarboxylic acid can be used, when needed.

Examples of the tetracarboxylic dianhydrides include pyromellitic dianhydride, 3,3',4,4'-benzophenonetetracarboxylic dianhydride, 3,3',4,4'-biphenyltetracarboxylic dianhydride, 3,3',4,4'-diphenylsulfonetetracarboxylic dianhydride, 1,2,5,6-naphthalenetetracarboxylic dianhydride, 2,3,5,6-pyridinetetracarboxylic dianhydride, 1,4,5,8-naphthalenetetracarboxylic dianhydride, 3,4,9,10-perylenetetracarboxylic dianhydride, 4,4'-sulfonyldiphthalic dianhydride, m-terphenyl-3,3',4,4'-tetracarboxylic dianhydride, 4,4'-oxydiphthalic dianhydride, 1,1,1,3,3,3-hexafluoro-2,2-bis(2,3- or 3,4-dicarboxyphenyl)propane dianhydride, 2,2-bis(2,3- or 3,4-dicarboxyphenyl)propane dianhydride, 2,2-bis[4-(2,3- or 3,4-dicarboxyphenoxy)phenyl]propane dianhydride, 1,1,1,3,3,3-hexafluoro-2,2-bis[4-(2,3- or 3,4-dicarboxyphenoxy)phenyl]propane dianhydride, 1,3-bis(3,4-dicarboxyphenyl)-1,1,3,3-tetramethyldisiloxane dianhydride, butanetetracarboxylic dianhydride and bicycle-[2,2,2]-oct-7-ene-2:3:5:6-tetracarboxylic dianhydride.

Examples of the aliphatic dicarboxylic acids include succinic acid, glutaric acid, adipic acid, azelaic acid, suberic acid, sebacic acid, decanoic diacid, dodecanoic diacid and dimer acid.

Examples of the aromatic dicarboxylic acids include isophthalic acid, terephthalic acid, phthalic acid, naphthalenedicarboxylic acid and oxydibenzoic acid.

It is preferable to further use a monohydroxyl compound that becomes an end capper in the production of the thermosetting urethane resin. The monohydroxyl compound has only to be a compound having one hydroxyl group in a molecule, and is, for example, an aliphatic alcohol or a monohydroxyl mono(meth)acrylate. Here, the (meth) acrylate means acrylate/methacrylate, and the same shall apply hereinafter.

Examples of the aliphatic alcohols include methanol, ethanol, propanol and isobutanol. An example of the monohydroxy mono (meth) acrylate is 2-hydroxyethyl acrylate. Use of such a compound makes it possible for an isocyanate group not to remain in the thermosetting urethane resin.

In the thermosetting urethane resin, a halogen such as chlorine or bromine or an atom such as phosphorus may be introduced into its structure in order to further impart flame retardance.

The blending ratio between the carbonate diol compound and the isocyanate compound in the reaction of them is preferably 50:100 to 150:100, more preferably 80:100 to 120:100, except the case where the acid anhydride group-containing thermosetting urethane resin is obtained.

Especially in the case where the carboxyl group-containing thermosetting urethane resin is obtained, the blending ratio in the reaction of a polyol having a carboxyl group together with the carbonate diol compound and the isocyanate compound is as follows. That is to say, when the carbonate diol compound, the isocyanate compound and the polyol having a carboxyl group are represented by (a), (b) and (c), respectively, the blending ratio is (a)+(c):(b) = 50:100 to 150:100, more preferably, (a)+(c):(b) = 80:100 to 120:100.

The solvent employable in the reaction of the polyol compound including the carbonate diol compound with the isocyanate compound is preferably a polar solvent containing no nitrogen.

Examples of ether-based solvents include diethylene glycol dimethyl ether, diethylene glycol diethyl ether, triethylene glycol dimethyl ether and triethylene glycol diethyl ether.

Examples of sulfur-containing-based solvents include dimethyl sulfoxide, diethyl sulfoxide, dimethyl sulfone and sulfolane. Examples of ester-based solvents include γ-butyrolactone, diethylene glycol monomethyl ether acetate, ethylene glycol monomethyl ether acetate, propylene glycol monomethyl ether acetate, diethylene glycol monoethyl ether acetate, ethylene glycol monoethyl ether acetate and propylene glycol monoethyl ether acetate.

Examples of ketone-based solvents include cyclohexanone and methyl ethyl ketone. Examples of aromatic hydrocarbon-based solvents include toluene, xylene and petroleum naphtha. These solvents can be used singly or in combination of two or more kinds.

Examples of solvents that are highly volatile and can give low-temperature curability include γ-butyrolactone, diethylene glycol monomethyl ether acetate, ethylene glycol monomethyl ether acetate, propylene glycol monomethyl ether acetate, diethylene glycol monoethyl ether acetate, ethylene glycol monoethyl ether acetate and propylene glycol monoethyl ether acetate.

The temperature for the reaction of the polyol compound including the carbonate diol compound with the isocyanate compound is preferably 30 to 180°C, more preferably 50 to 160°c. If the reaction temperature is lower than 30°C, the reaction time is too long, and if the reaction temperature exceeds 180°C, gelation is liable to take place.

The reaction time is preferably 2 to 36 hours, more preferably 8 to 16 hours, though it depends upon the reaction temperature. If the reaction time is less than 2 hours, control of the number-average molecular weight is difficult even if the reaction temperature is raised in order to obtain a desired number-average molecular weight. On the other hand, a reaction time of more than 36 hours is not practical.

The number-average molecular weight of the thermosetting urethane resin is preferably 500 to 100,000, more preferably 8,000 to 50,000. Here, the number-average molecular weight is a value in terms of polystyrene, which is measured by gel permeation chromatography. If the number-average molecular weight of the thermosetting urethane resin is less than 500, elongation, flexibility and strength of a cured film are liable to be impaired, and if the number-average molecular weight thereof exceeds 100,000, flexibility is liable to be lowered.

In particular, the acid value of the carboxyl group-containing thermosetting urethane resin is preferably 5 to 150 mgKOH/g, more preferably 30 to 120 mgKOH/g. If the acid value is less than 5 mgKOH/g, reactivity with the curable component is lowered, and expected heat resistance and long-term reliability are not obtained in some cases. If the acid value exceeds 150 mgKOH/g, flexibility is liable to be lost, and long-term insulation properties, etc. are sometimes lowered. The acid value of the resin is a value measured in accordance with JIS K5407.

In the discharge gap-filling composition of the present invention, the content of the binder component (B) is preferably 10 to 90 parts by mass, more preferably 20 to 60 parts by mass, still more preferably 30 to 50 parts by mass, when the content of the metal powder (A) is 100 parts by mass.

### [Diluent (C)]

The diluent (C) contained in the discharge gap-filling composition of the present invention is a diluent having two or more characteristic groups in a molecule, said characteristic groups being not directly bonded to each other but being bonded through a hydrocarbon group or a silicon atom. The characteristic group of the diluent (C) indicates a group other than a group constituted of one or more atoms selected from carbon, silicon and hydrogen, and indicates a group other than an oxy group (R-O-R') both sides (both of two bonding hands) of which are bonded to hydrocarbon groups and a thiosulfide group (R-S-R') both sides (both of two bonding hands) of which are bonded to hydrocarbon groups (here, R and R' are each a hydrocarbon group). The "hydrocarbon group" is a straight-chain or branched, chain or cyclic, saturated or unsaturated aliphatic hydrocarbon group, or an aromatic hydrocarbon group.

In the case where the discharge gap-filling composition does not contain this diluent (C), particle components such as the metal powder (A) and the later-described layered substance (D) are precipitated immediately after the preparation of the composition, even if the components are dispersed to prepare the composition. On this account, it becomes difficult to uniformly apply the composition to the desired portion, and in the production of an electrostatic discharge protector, the productivity is markedly deteriorated. On the other hand, when a composition contains the diluent (C) similarly to the discharge gap-filling composition of the present invention, aggregation of the particle components in the composition is reduced, and precipitation of the particle components with time can be decreased, and then, it is possible to produce an electrostatic discharge protector with high productivity.

That is to say, in the present invention, this diluent (C) has functions to dissolve the binder component (B), to favorably disperse the particle components such as the metal powder (A) and the later-described layered substance (D) in the composition and to inhibit aggregation or precipitation of the particle components such as the metal powder (A) and the later-described layered substance (D) after dispersing. Owing to such functions, precipitation of the particle components with time is decreased, and the coating properties (potting properties) are improved.

The reason is presumably that the surface of the metal powder (A) and the characteristic groups defined above in the diluent have properties of interaction such as hydrogen bonding, and a single molecule or associated plural molecules of the diluent are introduced (exist), as spacers, among particles of the particle components such as metal particles, and the characteristic groups of the diluent loosely undergo interaction with the particle components such as a metal powder, whereby strong aggregation of particles of the particle components such as meal particles is inhibited.

The diluent (C) is preferably volatile. The volatile diluent (C) is, for example, a diluent having a boiling point of not higher than 400°C, preferably not higher than 300°C. In the case where the discharge gap-filling composition contains such a diluent (C) and is thermally curable, the diluent is evaporated during thermal curing and rarely remains in the electrostatic discharge protector, so that troubles caused by the diluent remaining in the electrostatic protector, such as troubles of failure relating to electric properties and curability, can be prevented.

The surface of the metal powder (particularly surface of a film made of a metal oxide) of the present invention exhibits hydrophilicity, and therefore, of the above-defined characteristic groups, preferable is not a hydrophobic characteristic group but a hydrophilic characteristic group, from the viewpoint that particles of the particle components such as the metal particles (A) are apt to be present as spacers among such metal particles as above. Specifically, there can be mentioned a hydrophilic characteristic group containing a nitrogen atom, an oxygen atom, a phosphorus atom, a sulfur atom or a halogen atom.

More specifically, there can be mentioned a group selected from the group consisting of a hydroxyl group (-OH), an oxy group (-O-) at least one of two bonding hands of which is not bonded to a hydrocarbon group, an oxo group (=O), a carbonyl group (-CO-), an amino group (-NH₂), an imino group (-NR-), a halogen group (-F, -Cl, -Br, -I), an N-oxide group (-N=O), an N-hydroxyl group (-N(OH)-), a hydrazine group (-NH-NH₂), a nitro group (-NO₂), a nitroso group (-NO), an azo group (R-N=N-R'), a diazo group (-N=N-), an azide group (-N₃), a phosphino group (-PH₂), a thiosulfide group (-S-) at least one of two bonding hands of which is not bonded to a hydrocarbon group, an S-oxide group (=S-O), a thioxy group (=S) and a group wherein these groups are directly bonded to each other. From the viewpoints of toxicity, corrosiveness and electrical reliability, the characteristic group is preferably a hydroxyl group, an oxy group at least one of two bonding hands of which is not bonded to a hydrocarbon group, an oxo group, a carbonyl group and a group wherein these groups are directly bonded to each other, among them. R or R' in the imino group (-NR-) and the azo group (R-N=N-R') is a straight-chain or branched, chain or cyclic, saturated or unsaturated aliphatic hydrocarbon group, or an aromatic hydrocarbon group.

Here, the "group wherein the above groups given as examples are directly bonded to each other" is referred to a group wherein the above groups given as examples are directly bonded to each other without allowing a carbon atom, a silicon atom or the like to be present between them. For example, a group (ester linkage (-CO-O-)) wherein a carbonyl group (-CO-) and an oxy group (-O-) at least one of two bonding hands of which is not bonded to a hydrocarbon group are directly bonded to each other, a group (thioester linkage (-CO-S-)) wherein a carbonyl group (-CO-) and a thiosulfide group (-S-) at least one of two bonding hands of which is not bonded to a hydrocarbon group are directly bonded to each other, etc. can be mentioned, and the ester linkage (-CO-O-) and the thioester linkage (-CO-S-), each of which is a "group wherein the above groups are directly bonded", are each counted as one characteristic group.

The oxy group (-O-) and the thiosulfide group (-S-) are each a group at least one of two bonding hands of which is not bonded to a hydrocarbon group, and this "hydrocarbon group" indicates a straight-chain or branched, chain or cyclic, saturated or unsaturated aliphatic hydrocarbon group, or an aromatic hydrocarbon group.

The diluent (C) is not specifically restricted as far as it has two or more of such characteristic groups as above in a molecule and the characteristic groups are not directly bonded to each other in a molecule but are bonded through a hydrocarbon group or a silicon atom, and the diluent may be one having a straight-chain molecular structure, or may be one having a cyclic molecular structure.

Further, the diluent (C) is particularly preferably one having low toxicity and low odor, and is specifically a polyhydric alcohol having 2 or more, preferably 3 or more, more preferably 3 to 6 hydroxyl groups in one molecule, or a condensate such as an esterification product thereof or an ether thereof. More specifically, there can be mentioned dipropylene glycol, triacetin, glycerol, 1,1,3,3-tetramethoxypropane, 1,1,3,3-tetraethoxypropane, etc.

The content of the diluent (C) is preferably 10 to 90% by mass, more preferably 20 to 60% by mass, based on 100% by mass of the discharge gap-filling composition of the present invention, though it can be appropriately adjusted by the viscosity of the composition, the amount of the diluent contained in the metal powder (A), etc.

In the discharge gap-filling composition of the present invention, the content of the diluent (C) is preferably 50 to 10000 parts by mass, more preferably 100 to 1000 parts by mass, when the content of the metal powder (A) is 100 parts by mass.

In the discharge gap-filling composition of the present invention, further, the content ratio ((C)/(A)) of the diluent (C) to the metal powder (A) is preferably not less than 0.5, more preferably not less than 1. In the discharge gap-filling composition of the present invention, the content ratio ((C)/(C')) of the diluent (C) to a diluent (C') that is not the component (C) is preferably not less than 0.2. The diluent (C') indicates a diluent that is not the diluent (C), and is, for example, a solvent which is used in the preparation of the metal powder (A) or the binder component (B), is contained in the case of the preparation of the discharge gap-filling composition of the invention and does not correspond to the diluent (C).

### [Layered substance (D)]

The discharge gap-filling composition of the present invention preferably further contains a layered substance (D) from the viewpoint of obtaining better ESD protection properties.

The layered substance (D) is referred to a substance formed from plural layers bonded to one another by van der Waals force. In the layered substance (D), atoms, molecules and ions that do not inherently participate in constitution of crystals can be incorporated into the specific positions in the crystals by means of ion exchange or the like, and owing to this, the crystal structure does not change. The position into which an atom, a molecule or an ion is incorporated, that is, the host position, has a planar layered structure. Typical examples of such layered substances (D) include layered clay mineral (D1), layered carbon (D2) such as graphite (black lead), and chalcogenide of a transition metal. Those compounds exhibit their respective specific properties by incorporating metal atoms, inorganic molecules, organic molecules, etc. as guests into the host positions.

The layered substance (D) is characterized in that the distance between layers flexibly responds to the size of the guest or the interaction. The compound obtained by incorporating guests into the host positions is calledan intercalation compound. From combinations of hosts and guests, extremely various intercalation compounds exist. The guest present between layers is in a specific environment where the guest is restrained by the host layers in two directions. Therefore, it is thought that the characteristics of the guest present between layers are different from those of a guest adsorbed on the surface of the layer, and are characteristics that not only depend upon the structures and the properties of the host and the guest but also reflect the host-guest interaction. Further, it has been studied recently that the layered substance well absorbs electromagnetic waves and the layered substance having an oxide as the guest becomes an oxygen-absorbing/releasing material that absorbs or releases oxygen at a certain temperature. It is thought that the layered substance (D) having such characteristics undergoes an interaction with a hydrolysis product of a metal alkoxide or a self-oxidation film, and as a result, the discharge gap-filling composition containing the layered substance (D) is further improved in the ESD protection properties.

The layered substance (D) for use in the present invention is preferably at least one substance selected from the group consisting of layered clay mineral (D1) and layered carbon (D2).

Examples of the layered clay minerals (D1) of the layered substances (D) for use in the present invention include smectite group clay that is a swelling silicate and swelling mica.

Examples of the smectite group clays include montmorillonite, beidellite, nontronite, saponite, ferrosaponite, hectorite, sauconite, stevensite and bentonite, and their substituted compounds, derivatives and mixtures.

Examples of the swelling micas include lithium type taeniolite, sodium type taeniolite, lithium type tetrasilicic mica and sodium type tetrasilicic mica, and their substituted compounds, derivatives and mixtures. In the swelling micas, there is swelling mica having a structure similar to that of vermiculites, and such a vermiculite-corresponding product or the like is also employable.

The layered substance (D) is preferably layered carbon (D2). The layered carbon (D2) can release free electrons into the space between electrodes when ESD occurs. When the layered substance is the layered carbon (D2), operating properties during the ESD tend to become good.

Examples of the layered carbons (D2) include a low-temperature treatment product of coke, carbon black, metal carbide, carbon whisker and SiC whisker. Such layered carbon (D2) is also observed to have operating properties against ESD. Such layered carbon (D2) has a hexagonal plane of a carbon atom as a basic structure and has a relatively small number of layers laminated and slightly low regularity, so that short circuits tend to occur a little.

Therefore, the layered carbon (D2) is preferably at least one substance selected from the group consisting of carbon nanotube, vapor phase epitaxial carbon fiber, carbon fullerene, graphite and carbyne-based carbon, which have higher regularity in laminating.

Examples of the fibrous layered carbons (D2) include carbon nanotube, graphite whisker, filamentous carbon, graphite fiber, extra fine carbon tube, carbon tube, carbon fibril, carbon microtube and carbon nanofiber.

Such layered carbon (D2) may be used by mixing it with artificial diamond.

As the graphite, graphite having high laminating regularity is preferable, and for example, graphite of hexagonal crystal system such as hexagonal plate flat crystal, trigonal crystal system or rhombohedral crystal system can be mentioned. The carbyne-based carbon is preferably carbyne-based carbon wherein carbon atoms form a straight-chain, and as bonds between carbons, a single bond and a triple bond are alternately repeated, or carbons are linked by a double bond.

In such graphite or carbyne-based carbon, intercalates such as other atoms, ions or molecules can be readily intercalated between layers, and therefore, the graphite or the carbyne-based carbon is suitable as a catalyst accelerating oxidation or reduction of the metal powder (A). That.is to say, the layered carbons (D2) given as examples are characterized in that any of an electron donor and an electron acceptor can be intercalated into them.

In order to remove impurities, the layered carbon (D2) may be subjected to high-temperature treatment at about 2500 to 3200°C in an inert gas atmosphere, or may be subjected to high-temperature treatment at about 2500 to 3200 °C in an inert gas atmosphere together with a graphitization catalyst, such as boron, boron carbide, beryllium, aluminum or silicon.

As the layered substance (D), the layered mineral clay (D1), such as swelling silicate or swelling mica, and the layered carbon (D2) may be each used singly or in combination of two or more kinds. Of these, smectite group clay, graphite or vapor phase epitaxial carbon fiber is preferably used from the viewpoints of dispersibility in the binder component (B) and ease of obtaining.

When the layered substance (D) is spherical or flaky, the mean particle diameter is preferably not less than 0.01 µm but not more than 30 µm. If the mean particle diameter of the layered substance (D) exceeds 30 µm, electrical conduction between particles is liable to occur particularly in the case of the the layered carbon (D2), and it is sometimes difficult to obtain a stable ESD protector. On the other hand, if the mean particle diameter is less than 0.01 µm, cohesive force is high, and manufacturing problems such as high electrification properties sometimes occur.

When the layered substance (D) is spherical or flaky, the mean particle diameter is measured in the following manner. A sample of 50 mg is weighed and added to 50 ml of distilled water. Then, 0.2 ml of a 2% Triton (trade name of surface active agent manufactured by GE Healthcare Bioscience Co., Ltd.) aqueous solution is added, and the mixture is dispersed for 3 minutes by an ultrasonic homogenizer having an output of 150 W, followed by measuring a cumulative 50 mass% particle diameter using a laser diffraction particle size distribution meter, such as a laser diffraction light scattering type particle size distribution meter (trademark: Microtrack HRA, manufactured by Nikkiso Co., Ltd.). The resulting cumulative 50 mass% particle diameter is evaluated as a mean particle diameter.

When the layered substance (D) is fibrous, it is preferable that the mean fiber outside diameter is not less than 0.01 µm but not more than 0.3 µm and the mean fiber length is not less than 0.01 µm but not more than 20 µm, and it is more preferable that the mean fiber outside diameter is not less than 0.06 µm but not more than 0.2 µm and the mean fiber length is not less than 1 µm but not more than 20 µm. The mean fiber outside diameter and the mean fiber length of the fibrous layered substance (D) can be determined by measuring fiber diameters and fiber lengths of 10 fibers using an electron microscope and calculating mean values.

When the layered substance (D) is spherical or flaky, the occupancy ratio by mass of the layered substance (D) is preferably not less than 0.1% by mass but not more than 10% by mass in the solids content (100% by mass) of the discharge gap-filling composition. If the occupancy ratio exceeds 10% by mass, electrical conduction between the layered substances (D) is liable to occur, and heat storage during ESD is increased. Therefore, destruction of the resin or the substrate takes place, or after occurrence of ESD, restoration of insulation properties of the ESD protector tends to be delayed because of a high temperature. If the occupancy ratio is less than 0.1% by mass, operating properties for the ESDprotection sometimes become unstable.

When the layered substance (D) is fibrous, this substance comes into contact with the metal powder surface more effectively than the spherical or flaky layered substance, so that if the occupancy ratio by mass is too high, electrical conduction tends to easily occur. Therefore, when the layered substance (D) is fibrous, the occupancy ratio by mass of the layered substance (D) is preferably lower than that of the spherical or flaky layered substance, and is preferably not less than 0.01% by mass but not more than 5% by mass in the solids content (100% by mass) of the discharge gap-filling composition.

When the content of the metal powder (A) in the discharge gap-filling composition of the present invention is 100 parts by mass, the content of the layered substance (D) is preferably 1 to 100 parts by mass, more preferably 10 to 30 parts by mass.

### [Other components]

In the discharge gap-filling composition of the present invention, a curing catalyst, a curing accelerator, a filler, a diluent other than the diluent (C), a blowing agent, an anti-foaming agent, a leveling agent, a lubricant, a plasticizer, a rust proofing agent, a viscosity modifier, a colorant, etc. can be contained, when needed, in addition to the metal powder (A), the binder component (B) and the diluent (C). Further, insulating particles such as silica particles can be contained.

### [Preparation process for discharge gap-filling composition]

The discharge gap-filling composition of the present invention can be prepared by, for example, introducing the metal powder (A), the binder component (B) and the diluent (C), and if necessary, the layered substance (D) and other components, such as diluent (diluent (C')) other than the diluent (C), filler and curing catalyst, into a stirring device, such as disper, kneader, three-roll mill, bead mill or rotation/revolution type mixer, at the same time or in an arbitrary order and then dispersing/mixing them. In order to improve compatibility of the components with one another, they may be heated to a sufficient temperature during the dispersing/mixing. After the dispersing/mixing, a curing accelerator may be further added and mixed to prepare the discharge gap-filling composition of the present invention, when needed.

### <Electrostatic discharge protector>

The electrostatic discharge protector of the present invention is an electrostatic discharge protector having at least two electrodes and a discharge gap between the two electrodes, and is characterized by having a discharge gap filler member formed by filling the discharge gap with the aforesaid discharge gap-filling composition.

The two electrodes are arranged at a given distance. The space (discharge gap) between these two electrodes is filled with the discharge gap filler member, and the filler member is in a solidified or cured state. That is to say, the two electrodes are connected to each other through the discharge gap filler member.

In order to protect a device during electrostatic discharge, the electrostatic discharge protector of the present invention is preferably used as a protective circuit for allowing an overcurrent to escape to the earth.

The electrostatic discharge protector of the present invention has the discharge gap filler member formed by filling the discharge gap with the discharge gap-filling composition, and therefore, the protector is excellent in insulation properties in normal operation, operating voltage and resistance to high voltage. That is to say, in the case of a low voltage in normal operation, the electrostatic discharge protector of the present invention exhibits a high electrical resistance value and can supply a current to the device without allowing a current to escape to the earth. On the other hand, when electrostatic discharge occurs, the electrostatic discharge protector instantly exhibits a low electrical resistance value and allows an overcurrent to escape to the earth, whereby supply of the overcurrent to the device can be inhibited. Thereafter, when the transient phenomenon of electrostatic discharge disappears, the electrical resistance value is returned to a high value, and a current can be supplied to the device.

In the electrostatic discharge protector of the present invention, further, the discharge gap between two electrodes is filled with the discharge gap-filling composition having the insulating binder component (B), and therefore, leakage current does not occur in the normal operation. For example, the resistance value given when a voltage of not more than DC10V is applied between the two electrodes can be raised to not less than 10¹⁰ Ω, and electrostatic discharge protection can be realized.

The electrostatic discharge protector of the present invention can be produced by, for example, forming the discharge gap filler member in the following manner using the aforesaid discharge gap-filling composition. That is to say, the discharge gap-filling composition is prepared first by the aforesaid process. This discharge gap-filling composition is applied so as to cover the space (that becomes a gap) between the two electrodes by a method of potting, screen printing or the like, then heated if necessary, and solidified or cured to form the discharge gap filler member.

The width of the discharge gap is preferably not more than 500 µm, more preferably not less than 5 µm but not more than 300 µm. If the width of the discharge gap exceeds 500 µm, the electrostatic discharge performance tends to become non-uniform in every product, though the protector sometimes operates by making the width of the electrode for forming the discharge gap larger. Moreover, such a width goes against downsizing of electrostatic discharge protectors, so that such a width is undesirable. Also in the case of a discharge gap width of less than 5 µm, the electrostatic discharge performance tends to become non-uniform in every product and short circuit tends to occur under the influence of dispersibility of the metal powder (A) or the layered substance (D), so that such a width is undesirable. Here, the width of the discharge gap means the shortest distance between the electrodes.

Apref erred shape of the electrode of the electrostatic discharge protector can be arbitrarily determined according to the condition of the circuit board, and when downsizing is taken into account, a shape of a film having a rectangular section and having a thickness of, for example, 5 to 200 µm can be given as an example.

Apref erredwidth of the electrode of the electrostatic discharge protector is not less than 5 µm, and a larger electrode width is preferable because energy in the electrostatic discharge can be diffused. On the other hand, if the width of the electrode of the electrostatic discharge protector is a sharp width of less than 5 µm, energy in the electrostatic discharge is concentrated, and therefore, severe damage is done to the peripheral members including the electrostatic discharge protector itself, so that such a width is undesirable.

In the electrostatic discharge protector of the present invention, a protective layer is preferably formed on the surface of the discharge gap filler member.

When the adhesion of the aforesaid discharge gap-filling composition to a base on which the discharge gap has been provided is insufficient depending upon a material of the base, the energy of the electrostatic discharge becomes extremely high in some cases, or the occupancy ratio by mass of the metal powder (A) becomes high in some cases.

Even in such cases, the electrostatic discharge protector of the present invention is imparted with resistance to higher voltage and can maintain excellent repetition resistance by forming a discharge gap filler member and then providing a protective layer of the later-described resin composition or the like so as to cover the discharge gap filler member.

The resin used for the protective layer is, for example, a natural resin, a modified resin or an oligomer synthetic resin.

A typical natural resin is rosin. Examples of the modified resins include rosin derivatives and rubber derivatives. The oligomer synthetic resin is, for example, a silicon resin, and examples thereof include such resins as used in combination with a polysiloxane compound of the electrostatic discharge protector, such as epoxy resin, acrylic resin, maleic acid derivative, polyester resin, melamine resin, urethane resin, imide resin, amic acid resin and imide/amide resin.

A resin composition can be used for the protective layer.

In order to keep strength of a coating film of the resin composition, the resin composition preferably contains a curable resin capable of being cured by heat or ultraviolet rays.

Examples of the thermosetting resins include a carboxyl group-containing urethane resin, an epoxy compound, a combination of a compound containing acid anhydride group, carboxyl group, alcohol group or amino group and an epoxy compound, and a combination of a compound containing carboxyl group, alcohol group or amino group and a compound containing carbodiimide.

Examples of the epoxy compounds include epoxy compounds having two or more epoxy groups in one molecule, such as bisphenol A type epoxy resin, hydrogenated bisphenol A type epoxy resin, brominated bisphenol A type epoxy resin, bisphenol F type epoxy resin, novolak type epoxy resin, phenol novolak type epoxy resin, cresol novolak type epoxy resin, alicyclic epoxy resin, N-glycidyl type epoxy resin, novolak type epoxy resin of bisphenol A, chelate type epoxy resin, glyoxal type epoxy resin, amino group-containing epoxy resin, rubber modified epoxy resin, dicyclopentadiene phenolic type epoxy resin, silicone modified epoxy resin and ε-caprolactone modified epoxy resin.

In order to impart flame retardance, an epoxy compound wherein a halogen such as chlorine or bromine or an atom such as phosphorus has been introduced into its structure may be used. Moreover, bisphenol S type epoxy resin, diglycidyl phthalate resin, heterocyclic epoxy resin, bixylenol type epoxy resin, biphenol type epoxy resin, tetraglycidyl xylenoyl ethane resin, etc. may be used.

As the epoxy resin, an epoxy compound having two or more epoxy groups in one molecule is preferably used. However, an epoxy compound having only one epoxy group in one molecule may be used in combination. The compound containing a carboxyl group is not specifically restricted, and an acrylate compound can be also mentioned. Similarly, the compound containing an alcohol group and the compound containing an amino group are not specifically restricted.

Examples of the ultraviolet ray-curable resins include an acrylic copolymer that is a compound containing two or more ethylenically unsaturated groups, an epoxy (meth) acrylate resin and a urethane (meth)acrylate resin.

The resin composition for forming the protective layer may contain a curing accelerator, a filler, a solvent, a blowing agent, an anti-foaming agent, a leveling agent, a lubricant, a plasticizer, a rust proofing agent, a viscosity modifier, a colorant, etc., when needed.

Although the thickness of the protective layer is not specifically restricted, it is preferably 0.1 µm to 1 mm. It is preferable that the protective layer completely covers the discharge gap filler member formed from the discharge gap-filling composition. If the protective layer has a deficiency, the possibility of occurrence of cracks caused by high energy during electrostatic discharge is increased.

Specific embodiments of the electrostatic discharge protector of the present invention are described in detail using Figs. 1 to 3. Fig. 1 is a vertical sectional view of an electrostatic discharge protector 11 that is one specific embodiment of the electrostatic discharge protector of the present invention. The electrostatic discharge protector 11 is formed from an electrode 12A, an electrode 12B and a discharge gap filler member 13. The electrode 12A and the electrode 12B are arranged in such a manner that their axial directions coincide with each other and their end surfaces face each other. Between the face-to-face end surfaces of the electrode 12A and the electrode 12B, a discharge gap 14 is formed. The discharge gap filler member 13 is formed in the discharge gap 14, and is provided so as to cover, from the upper side, the end of the electrode 12A, said end facing the end surface of the electrode 12B, and the end of the electrode 12B, said end facing the end surface of the electrode 12A, and so as to be in contact with these ends. The width of the discharge gap 14, that is, the distance between the face-to-face end surfaces of the electrode 12A and the electrode 12B, is preferably not less than 5 µm but not more than 300 µm.

Fig. 2 is a vertical sectional view of an electrostatic discharge protector 21 that is another specific embodiment of the electrostatic discharge protector of the present invention. The electrostatic discharge protector 21 is formed from an electrode 22A, an electrode 22B and a discharge gap filler member 23. The electrode 22A and the electrode 22B are arranged opposite to each other in such a manner that they are parallel with each other and their ends overlap in the vertical direction. In the region where the electrode 22A and the electrode 22B overlap in the vertical direction, a discharge gap 24 is formed. The discharge gap fillermember 23 has a rectangular section shape and is formed in the discharge gap 24. The width of the discharge gap24, thatis, the distance between the electrode 22A and the electrode 22B in the region where the electrode 22A and the electrode 22B overlap in the vertical direction is preferably not less than 5 µm but not more than 300 µm.

Fig. 3 is a vertical sectional view of an electrostatic discharge protector 31 that is one specific embodiment of the electrostatic discharge protector of the present invention. The electrostatic discharge protector 31 is formed on a base made of, for example, a polyimide film, and is formed from an electrode 32A, an electrode 32B, a discharge gap filler member 33 and a protective layer 35. The electrode 32A and the electrode 32B are arranged in such a manner that their axial directions coincide with each other and their end surfaces face each other. Between the face-to-face end surfaces of the electrode 32A and the electrode 32B, a discharge gap 34 is formed. The discharge gap filler member 33 is formed in the discharge gap 34, and is provided so as to cover, from the upper side, the end of the electrode 32A, said end facing the end surface of the electrode 32B, and the end of the electrode 32B, said end facing the end surface of the electrode 32A, and so as to be in contact with these ends. The width of the discharge gap 34, that is, the distance between the face-to-face end surfaces of the electrode 32A and the electrode 32B is preferably not less than 5 µm but not more than 300 µm.

### [Uses]

The electronic circuit board of the present invention has the aforesaid electrostatic discharge protector. Therefore, the electronic circuit board of the present invention tends to be rarely destroyed by static electricity even if it receives electrostatic discharge.

The flexible electronic circuit board of the present invention has the aforesaid electrostatic discharge protector. Therefore, the flexible electronic circuit board of the present invention tends to be rarely destroyed by static electricity even if it receives electrostatic discharge.

The electronic equipment of the present invention has the electronic circuit board or the flexible electronic circuit board. Therefore, the electronic equipment of the present invention tends to be rarely destroyed by static electricity even if it receives electrostatic discharge.

### EXAMPLES

The present invention is further described with reference to the following examples, but it should be construed that the present invention is in no way limited to those examples.

### [Evaluation criteria]

Properties of the discharge gap-filling compositions and the electrostatic discharge protectors obtained in the examples were evaluated in the following manner.

### <Coating properties (potting properties) of discharge gap-filing composition>

A syringe was filled with the discharge gap-filling composition and set on a special purpose adaptor in such a manner that the discharge part of the syringe fronted in the vertical direction. Thereafter, using a rotation/revolution type mixing defoaming machine "ARE-310" (manufactured by Thinky Co. , Ltd.), mixing was carried out for 4 minutes under the conditions of a revolution speed of 2000 rpm and a rotation speed of 800 rpm.

Thereafter, "Needle DPN-23G-1" (manufactured by Musashi Engineering, Inc.) was set to the discharge part of the syringe, and using a 3-axis dispensing micro-robot "EzROBO-3GX" (manufactured by Iwashita Engineering Inc.) and an automatic system dispenser "AD3000C" (manufactured by Iwashita Engineering, Inc.), continuous potting (continuous discharging) was carried out on a substrate (glass epoxy substrate) at 23 °C for 4 hours at rates of 0.2 mg/point and 1. 6 points/sec (total: 23718 points). A mean diameter (initial potting diameter (d1)) of 10 potting points between the 51st point from the beginning of the continuous potting and the 60th point and a mean diameter (d2) of 10 potting points between the 23659th point from the beginning of the continuous potting and the 23668th point were measured.

Subsequently, a ratio of (d2) to (d1) ((d2)/(d1)×100) was determined. From the ratio determined and the condition of discharge in 4 hours from the beginning of the continuous potting, the potting properties (coating properties) were evaluated by the following criteria.

### (Evaluation criteria)

AA: (d2)/(d1)×100 ≥ 90 (%)
BB: (d2)/(d1)×100 < 90 (%), or continuous potting cannot be carried out stably because choking of the tip of the syringe, etc. take place in 4 hours from the beginning of the continuous potting.

In the case of "AA" in the above evaluation, aggregation of the particle component (metal powder) in the composition is reduced, and precipitation of the particle component with time is decreased. On the other hand, in the case of "BB" in the above evaluation, aggregation of the particle component in the composition takes place, and precipitation of the particle component is increased with time.

### <Evaluation method for insulation properties at normal operating voltage>

As for the electrodes present at the both ends of the electrostatic discharge protector, a resistance under application of DC10V was measured as a "resistance in normal operation" using an insulation resistance meter "MEGOHMMETER SM-8220" (manufactured by DKK-TOA CORPORATION). From the measured value, insulation properties of the electrostatic discharge protector at a normal operating voltage were evaluated by the following criteria.

### (Criteria)

AA: The electrical resistance value is not less than 10¹⁰ Ω.
BB: The electrical resistance value is less than 10¹⁰ Ω.

### <Evaluation method for operating voltage>

Using a static electricity tester for semiconductors ESS-6008 (manufactured by NOISE LABORATORY Co., Ltd.), a voltage of 100 V was first applied to the resulting electrostatic discharge protector, then the voltage applied was increased by 50 V at a time to carry out current measurement, and an applied voltage at which a discharge current had flowed was evaluated as an "operating voltage". In the case where the discharge current was measured by the first application of 100 V, the operating voltage was taken as 100 V.

### <Evaluation method for resistance to high voltage>

The resulting electrostatic discharge protector was set on a static electricity tester for semiconductors ESS-6008 (manufactured by NOISE LABORATORY Co., Ltd.), and a voltage of 8 kV was applied 10 times. Thereafter, using an insulation resistance meter "MEGOHMMETER SM-8220", a resistance value under application of DC10V was measured. The resistance value was evaluated as "resistance to high voltage" by the following criteria.

### (Criteria)

AA: The resistance value is not less than 10¹⁰ Ω.
BB: The resistance value is not less than 10⁸ Ω but less than 10¹⁰ Ω.
CC: The resistance value is less than 10⁸ Ω.

### <Preparation Example 1 for surface-coated metal powder (A)>

As the metal powder (A), aluminum particles (trade name: 2173, solids content: 65%) manufactured by Showa Aluminum Powder K. K. were used. The primary particle of the aluminum particle had a thin-leaf shape. ,

The surfaces of the aluminum particles were each coated with a film made of a hydrolysis product of a metal alkoxide in the following manner. As the metal alkoxide, tetraethoxysilane was used.

76 g of thin-leaf aluminum particles (trade name: 2173, solids content: 65%) manufactured by Showa Aluminum Powder K. K. were weighed out and dispersed in 724 g of propylene glycol monomethyl ether. To this dispersion, 169 g of ion-exchanged water and 32 g of 25 mass% aqueous ammonia were added, and they were stirred to obtain an aluminum powder slurry. The liquid temperature of this aluminum powder slurry was maintained at 30°C.

Next, 13.2 g of tetraethoxysilane was diluted with 13.2 g of propylene glycol monomethyl ether. This dilute solution was dropwise added to the aluminum powder slurry at a given rate over a period of 12 hours, and with a progress of hydrolysis of tetraethoxysilane, surface coating of the aluminum particles with a hydrolysis product of tetraethoxysilane was carried out.

After the dropwise addition, stirringwas continued for 12 hours, and the temperature was maintained at 30°C. Thereafter, the aluminum powder having been subj ected to surface coating of aluminum particles with a hydrolysis product of tetraethoxysilane was washed with propylene glycol monomethyl ether three times. After the washing, the solvent was scattered at 40°C to obtain a paste (also described as an "aluminum powder-containing paste 1" hereinafter) containing aluminum solids, propylene glycol monomethyl ether and water. When the amount of the whole paste was 100% by mass, the contents of the aluminum solids, propylene glycol monomethyl ether and water were 41% by mass, 58.5% by mass and 0.5% by mass, respectively.

In the calculation of the solids content, the amount of the residue given after the paste having been drawn out was dried at 120 °C for 1 hour was divided by the amount of the paste before drying, and the resulting value was taken as the solids content. The operation of scattering of solvent at 40°C was completed after it was confirmed that the solids content became 41% by mass.

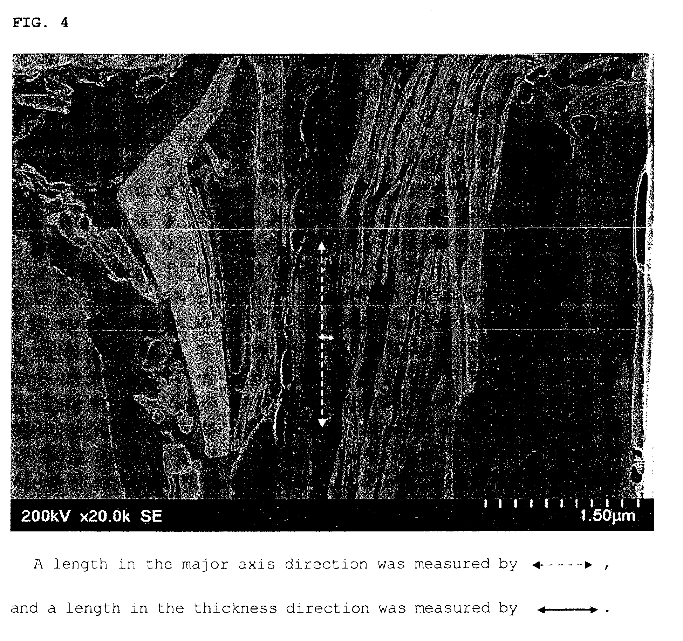

Further, the surface-coated aluminum particles were subjected to formation of section and observed under a scanning electron microscope (also described as "SEM" hereinafter) of 20000 magnifications. From the aluminum particles observed, 10 particles were arbitrarily selected, and with regard to each of the selected particles, a length "L" of the longest axis (longer side) and a length "d" of the shortest axis corresponding thereto were measured. A mean aspect ratio (L/d) determined from mean values of 10 L values and 10 d values was 20. One example of an SEM image used for the measurement is shown in Fig. 4.

### <Preparation Example 2 for surface-coated metal powder (A)>

As primary particles of the metal powder (A), aluminum particles (trade name: 08-0076, mean particle diameter: 2.5 µm) manufactured by Toyo Aluminum Powder K.K. were used. The aluminum particle had a spherical shape.

The surfaces of the aluminum particles were each coated with a filmmade of a hydrolysis product of a metal alkoxide in the following manner. As the metal alkoxide, tetraethoxysilane was used.

49 g of spherical aluminum particles (trade name: 08-0076, mean particle diameter: 2. 5 µm) manufactured by Toyo Aluminum Powder K. K. were weighed out and dispersed in 724 g of propylene glycol monomethyl ether. To this dispersion, 169 g of ion-exchanged water and 32 g of 25 mass% aqueous ammonia were added, and they were stirred to obtain an aluminum powder slurry. The liquid temperature of this aluminum powder slurry was maintained at 30°C.

Next, 13.2 g of tetraethoxysilane was diluted with 13.2 g of propylene glycol monomethyl ether. This dilute solution was dropwise added to the aluminum powder slurry at a given rate over a period of 12 hours, and with a progress of hydrolysis of tetraethoxysilane, surface coating of the aluminum particles with a hydrolysis product of tetraethoxysilane was carried out.

After the dropwise addition, stirringwas continued for 12 hours, and the temperature was maintained at 30°C. Thereafter, the aluminum powder having been subjected to surface coating of aluminum particles with a hydrolysis product of tetraethoxysilane was washed with propylene glycol monomethyl ether three times. After the washing, the solvent was scattered at 40°C to obtain a paste (also described as an "aluminum powder-containing paste 2" hereinafter) containing aluminum solids, propylene glycol monomethyl ether and water. When the amount of the whole paste was 100% by mass, the contents of the aluminum solids, propylene glycol monomethyl ether and water were 35% by mass, 64.5% by mass and 0.5% by mass, respectively.

In the calculation of the solids content, the amount of the residue given after the paste having been drawn out was dried at 120 °C for 1 hour was divided by the amount of the paste before drying, and the resulting value was taken as the solids content. The operation of scattering of solvent at 40°C was completed after it was confirmed that the solids content became 35% by mass.

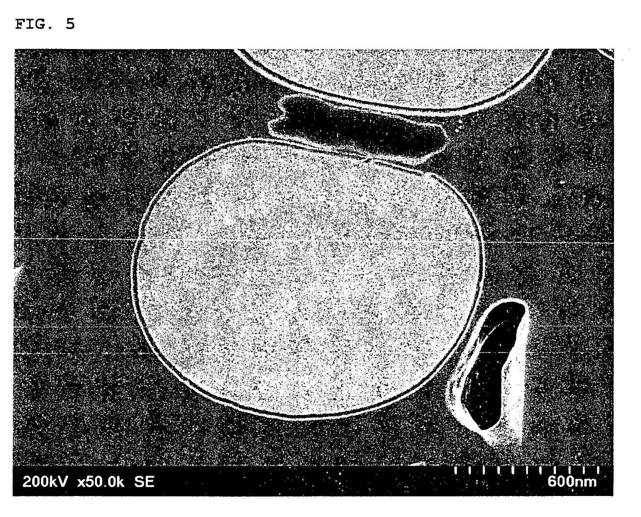

Further, the surface-coated aluminum particles were subjected to formation of section and observed under a scanning electron microscope (also described as "SEM" hereinafter) of 50000 magnifications. The aspect ratio (L/d) determined in the same manner as in Preparation Example 1 was 1.2. One example of an SEM image used for the measurement is shown in Fig. 5.

### <Synthesis Example 1 for binder component (B)>

As the binder component (B), a thermosetting urethane resin 1 was synthesized in the following manner. In a reaction container equipped with a stirring device, a thermometer and a condenser, 718.2 g of C-1015N (polycarbonate diol manufactured by Kuraray Co., Ltd., raw material diol molar ratio; 1,9-nonanediol:2-methyl-1,8-octanediol = 15:85, molecular weight; 964) as polycarbonate diol, 136.6 g of 2,2-dimethylolbutanoic acid (manufactured by Nippon Kasei Chemical Co., Ltd.) as a dihydroxyl compound having a carboxyl group, and 1293 g of γ-butyrolactone as a solvent were placed, and all the raw materials were dissolved at 90°C.

The temperature of the solution containing the raw materials dissolved was lowered down to 70°C, and 237.5 g of methylenebis(4-cyclohexyl isocyanate) (manufactured by Sumika Bayer Urethane Co., Ltd., trade name: "Desmodur-W") was dropwise added as polyisocyanate by the use of a dropping funnel over a period of 30 minutes.

After the dropwise addition was completed, the reaction was carried out at 80°C for 1 hour, then at 90°C for 1 hour and at 100°C for 1.5 hours, and disappearance of almost all the isocyanate was confirmed. Thereafter, 2.13 g of isobutanol (manufactured by Wako Pure Chemical Industries, Ltd.) was dropwise added, and the reaction was further carried out at 105°C for 1 hour to obtain a carboxyl group-containing urethane resin (also described as a "thermosetting urethane resin 1" hereinafter).

The resulting thermosetting urethane resin 1 had a number-average molecular weight of 6090 and a solids acid value of 40.0 mgKOH/g.

To the resulting thermosetting urethane resin 1 was added γ-butyrolactone to dilute the resin, whereby a solution (also described as a "thermosetting urethane resin solution 1" hereinafter) was obtained. When the amount of the thermosetting urethane resin solution was 100% by mass, the contents of the solids, γ-butyrolactone and isobutanol were 45% by mass, 55% by mass and 0.09% by mass, respectively.

### <Synthesis Example 2 for binder component (B)>

As the binder component (B), a thermosetting urethane resin 2 was synthesized in the following manner.

In a 5-liter four-neck flask equipped with a stirrer, a cooling pipe having an oil/water separator, a nitrogen feed pipe and a thermometer, 1000.0 g (0.50 mol) of PLACCEL CD-220 (trade name, 1,6-hexanediol-based polycarbonate diol manufactured by Daicel Chemical Industries, Ltd.), 250.27 g (1.00 mol) of 4,4'-diphenylmethane diisocyanate and 833.51 g of γ-butyrolactone were placed, and they were heated up to 140°C. The reaction was carried out at 140°C for 5 hours to obtain second diisocyanate. To the reaction solution, 288.20 g (1.50 mol) of trimellitic anhydride as polycarboxylic acid having an anhydride group, 125.14 g (0.50 mol) of 4,4'-diphenylmethane diisocyanate and 1361.14 g of γ-butyrolactone were further added, then the mixture was heated up to 160°C, and thereafter, the reaction was carried out for 6 hours to obtain an acid anhydride group-containing thermosetting urethane resin (also described as a "thermosetting urethane resin 2" hereinafter). The resulting thermosetting urethane resin 2 was diluted with γ-butyrolactone to obtain an amidoimide resin solution having a viscosity of 160 Pa·s and a solids content of 42% by mass, that is, a solution of the thermosetting urethane resin 2 (also described as a "thermosetting urethane resin solution 2" hereinafter). When the amount of the thermosetting urethane resin solution was 100% by mass, the contents of the solids and γ-butyrolactone were 42% by mass and 58% by mass, respectively.

### [Example 1]

### <Preparation of discharge gap-filling composition>

To 49 g of the aluminum powder-containing paste 1 (solids content: 41% by mass) prepared in Preparation Example 1, 18.2 g of the thermosetting urethane resin solution 1 (solids content: 45% by mass) prepared in Synthesis Example 1 was added, then 0.63 g of an epoxy resin (JER604 manufactured by Japan Epoxy Resins Co., Ltd.) was added as a curing agent, then 45 g of dipropylene glycol (manufactured by Wako Pure Chemical Industries, Ltd.) was added as a diluent, and using a homogenizer, they were stirred at 2000 rpm for 15 minutes to obtain a discharge gap-filling composition 1. The "dipropylene glycol" used herein as a diluent has two hydroxyl groups (-OH) as characteristic groups in a molecule. These characteristic groups (two hydroxyl groups) are not directly bonded to each other in a molecule but are bonded through a hydrocarbon group. Therefore, the "dipropylene glycol" corresponds to the diluent (C) defined in the present specification. The oxy group (-O-) is a group all the two bonding hands of which are bonded to hydrocarbon groups, and therefore, this oxy group is not a characteristic group defined in the present specification.

### <Preparation and evaluation of electrostatic discharge protector>

To a wiring board in which a pair of electrode patterns (film thickness: 12 µm, width of discharge gap: 70 µm, electrode width: 300 µm) had been formed on a polyimide film having a film thickness of 25 µm, the discharge gap-filling composition 1 was applied by the use of a flat needle having a needle tip diameter of 2 mm to fill the discharge gap between the electrode patterns with the composition. Then, the wiring board was held in a constant temperature container at 120°C for 60 minutes to form a discharge gap filler member. Thereafter, a silicon resin (X14-B2334, manufactured by Momentive Performance Materials Inc.) was applied so as to completely cover the electrostatic protector, and it was immediately placed in a curing oven at 120°C and cured at 120°C for 1 hour to form a protective layer, whereby such an electrostatic discharge protector 1 as shown in Fig. 3 was obtained. With regard to the resulting electrostatic discharge protector 1, insulation properties in normal operation, operating voltage and resistance to high voltage were evaluated based on the aforesaid "evaluation criteria" . The results are set forth in Table 1.

### [Example 2]

A discharge gap-filling composition 2 was prepared in the same manner as in Example 1, except that 45 g of triacetin (manufactured by Wako Pure Chemical Industries, Ltd.) was used as a diluent instead of 45 g of dipropylene glycol (manufactured by Wako Pure Chemical Industries, Ltd.). The "triacetin" used herein as a diluent has three ester linkages (-CO-O-) as characteristic groups in a molecule, and these characteristic groups are not directly bonded to each other in a molecule but are bonded through a hydrocarbon group. Therefore, the "triacetin" corresponds to the diluent (C) defined in the present specification. Next, an electrostatic discharge protector 2 was prepared in the same manner as in Example 1, except that the discharge gap-filling composition 2 was used. Then, various properties were evaluated. The results are set forth in Table 1.

### [Comparative Example 1]

A discharge gap-filling composition 3 was prepared in the same manner as in Example 1, except that 45 g of γ-butyrolactone (manufactured by Wako Pure Chemical Industries, Ltd.) was used as a diluent instead of 45 g of dipropylene glycol (manufactured by Wako Pure Chemical Industries, Ltd.) . Although the "γ-butyrolactone" used herein as a diluent has a carbonyl group (CO-) and an oxy group (-O-) as characteristic groups in a molecule, these characteristic groups are directly bonded to each other to form an ester linkage (-CO-O-). This ester linkage is counted as one characteristic group, and there is no characteristic group other than this ester linkage. Therefore, the "γ-butyrolactone" does not correspond to the diluent (C) defined in the present specification but corresponds to the diluent (C'). Next, an electrostatic discharge protector 3 was prepared in the same manner as in Example 1, except that the discharge gap-filling composition 3 was used. Then, various properties were evaluated. The results are set forth in Table 1.

[Table 1]

**Table 1**

| (Unit in blending: g) | | | | |
|---|---|---|---|---|
| Test Example | | Ex.1 | Ex. 2 | Comp. Ex. 1 |
| Discharge gap-filling composition | | Discharge gap-filling composition 1 | Discharge gap-filling composition 2 | Discharge gap-filling composition 3 |
| Metal powder | Aluminum powder-containing paste 1 (solids content) | 49(20.1) | 49(20.1) | 49(20.1) |
| Binder component (B) | Thermosetting urethane resin solution 1 (solids content) | 18.2(8.19) | 18.2(8.19) | 18.2(8.19) |
| Diluent (C) | Dipropylene glycol | 45 | 0 | 0 |
| | Triacetin | 0 | 45 | 0 |
| Diluent (C') | γ-Butyrolactone | 10.0 | 10.0 | 55.0 |
| | Propylene glycol monomethyl ether | 28.7 | 28.7 | 28.7 |
| | Water | 0.25 | 0.25 | 0.25 |
| | Isobutanol | 0.02 | 0.02 | 0.02 |
| | Subtotal | 38.9 | 38.9 | 83.9 |
| (C)/(C') content ratio | | 1.2 | 1.2 | 0 |
| Total weight | | 112.2 | 112.2 | 112.2 |
| (C)/(A) content ratio | | 2.2 | 2.2 | 0 |
| Evaluation | Coating properties (potting properties) | AA | AA | CC |
| | Insulation properties in normal operation | AA | AA | AA |
| | Operating voltage (V) | 250 | 250 | 250 |
| | Resistance to high voltage | AA | AA | AA |

As can be seen from the results in Table 1, with regard to the insulating properties in normal operation, the operating voltage and the resistance to high voltage, the electrostatic discharge protectors prepared using any of the discharge gap-filling compositions exhibited the same results. However, with regard to the coating properties (potting properties) of the discharge gap-filling compositions, the cases (Examples 1 and 2) containing a specific diluent exhibited extremely good results as compared with the case (Comparative Example 1) using a diluent other than the specific diluent.

That is to say, it can be seen that owing to the diluent (C) contained as a diluent in the discharge gap-filling composition, aggregation of the particle components in the composition, such as a metal powder, is reduced and precipitation of the particle components with time can be decreased, so that extremely good coating properties (potting properties) are exhibited.

### INDUSTRIAL APPLICABILITY

According to the present invention, a discharge gap-filing composition, which has good coating properties (potting properties) because aggregation of particle components in the composition, such as a metal powder, is reduced and precipitation of the particle components with time is decreased, can be provided. By the use of the composition, an electrostatic discharge protector having excellent operating properties during discharge and capable of being downsized and being reduced in cost can be provided.

### REFERENCE SIGNS LIST

- 11:: electrostatic discharge protector
- 12A:: electrode
- 12B:: electrode
- 13:: discharge gap filler member
- 14:: discharge gap
- 21:: electrostatic discharge protector
- 22A:: electrode
- 22B:: electrode
- 23:: discharge gap filler member
- 24:: discharge gap
- 31:: electrostatic discharge protector
- 32A:: electrode
- 32B:: electrode
- 33:: discharge gap filler member
- 34:: discharge gap
- 35:: protective layer

## Claims

1. A discharge gap-filling composition comprising a metal powder (A), a binder component (B) and a diluent (C), wherein the diluent (C) has two or more characteristic groups in a molecule, and the characteristic groups are not directly bonded to each other in a molecule but are bonded to each other through a hydrocarbon group or a silicon atom.

2. The discharge gap-filling composition as claimed in claim 1, wherein the content of the binder component (B) is 10 to 90 parts by mass and the content of the diluent (C) is 50 to 10000 parts by mass, based on 100 parts by mass of the content of the metal powder (A).

3. The discharge gap-filling composition as claimed in claim 1 or 2, wherein the characteristic groups of the diluent (C) are hydrophilic characteristic groups.

4. The discharge gap-filling composition as claimed in any one of claims 1 to 3, wherein the characteristic groups of the diluent (C) are hydrophilic characteristic groups each containing at least one atom selected from the group consisting of a nitrogen atom, an oxygen atom, a phosphorus atom, a sulfur atom and a halogen atom.

5. The discharge gap-filling composition as claimed in any one of claims 1 to 4, wherein the characteristic groups of the diluent (C) are each selected from the group consisting of a hydroxyl group, an oxy group at least one of two bonding hands of which is not bonded to a hydrocarbon group, an oxo group, a carbonyl group, an amino group, an imino group, a halogen group, an N-oxide group, an N-hydroxyl group, a hydrazine group, a nitro group, a nitroso group, an azo group, a diazo group, an azide group, a phosphino group, a thiosulfide group at least one of two bonding hands of which is not bonded to a hydrocarbon group, an S-oxide group, a thioxy group and groups in which these are directly bonded to each other.

6. The discharge gap-filling composition as claimed in any one of claims 1 to 4, wherein the characteristic groups of the diluent (C) are each selected from the group consisting of a hydroxyl group, an oxy group at least one of two bonding hands of which is not bonded to a hydrocarbon group, an oxo group, a carbonyl group and groups in which these are directly bonded to each other.

7. The discharge gap-filling composition as claimed in any one of claims 1 to 6, wherein the diluent (C) is at least one substance selected from the group consisting of dipropylene glycol, triacetin, glycerol, 1,1,3,3-tetramethoxypropane and 1,1,3,3-tetraethoxypropane.

8. The discharge gap-filling composition as claimed in any one of claims 1 to 7, wherein the surfaces of primary particles of the metal powder (A) are coated with a film made of a metal oxide.

9. The discharge gap-filling composition as claimed in claim 8, wherein the film made of a metal oxide is a film made of a hydrolysis product of a metal alkoxide represented by the following formula (1) : 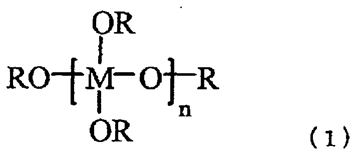 wherein M is a metal atom, O is an oxygen atom, each R is independently an alkyl group of 1 to 20 carbon atoms, and n is an integer of 1 to 40.

10. The discharge gap-filling composition as claimed in claim 9, wherein M in the formula (1) is silicon, titanium, zirconium, tantalum or hafnium.

11. The discharge gap-filling composition as claimed in any one of claims 1 to 10, further comprising a layered substance (D).

12. The discharge gap-filling composition as claimed in claim 8, wherein the film made of a metal oxide is a self-oxidation film formed from the primary particle itself of the metal powder (A).

13. The discharge gap-filling composition as claimed in any one of claims 1 to 12, wherein the metal powder (A) is at least one metal powder selected from the group consisting of copper, silver, gold, zinc, iron, tungsten, manganese, niobium, zirconium, hafnium, tantalum, molybdenum, vanadium, nickel, cobalt, chromium, magnesium, titanium, aluminum and alloys of these metals.

14. The discharge gap-filling composition as claimed in any one of claims 1 to 13, wherein the binder component (B) contains a thermosetting compound or an active energy ray-curable compound.

15. An electrostatic discharge protector having at least two electrodes and a discharge gap between the two electrodes, and having a discharge gap filler member formed by filling the discharge gap with the discharge gap-filling composition as claimed in any one of claims 1 to 14.

16. An electronic circuit board having the electrostatic discharge protector as claimed in claim 15.

17. A flexible electronic circuit board having the electrostatic discharge protector as claimed in claim 15.
